(19) Europäisches Patentamt
European Patent Office
Office européen des brevets

(11) EP 2 610 041 A1

(12) EUROPEAN PATENT APPLICATION
published in accordance with Art. 153(4) EPC

(43) Date of publication:
03.07.2013 Bulletin 2013/27

(51) Int Cl.:
*B29B 7/58* (2006.01)     *B29B 7/48* (2006.01)
*B29B 9/06* (2006.01)     *B29B 9/14* (2006.01)
*B29C 47/92* (2006.01)

(21) Application number: 11819736.7

(22) Date of filing: 27.07.2011

(86) International application number:
PCT/JP2011/067120

(87) International publication number:
WO 2012/026271 (01.03.2012 Gazette 2012/09)

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR

(30) Priority: 27.08.2010 JP 2010191542

(71) Applicant: Polyplastics Co., Ltd.
Tokyo 108-8280 (JP)

(72) Inventors:
• HIRATA, Kunihiro
Fuji-shi
Shizuoka 416-8533 (JP)

• ISHIDA, Hiroshi
Fuji-shi
Shizuoka 416-8533 (JP)
• HIRAGORI, Motohito
Fuji-shi
Shizuoka 416-8533 (JP)

(74) Representative: Maiwald Patentanwalts GmbH
Elisenhof
Elisenstrasse 3
80335 München (DE)

(54) **SIMULATION DEVICE, PROGRAM, AND RECORDING MEDIUM**

(57) To provide a simulation device for deriving a manufacturing condition that enables break-down of a glass fiber bundle that is not broken down, being a cluster of monofilaments, into monofilaments, in manufacturing a resin molded article using a bi- or multi-axial extruder of an engaging type, a program for realizing a function of said simulation device, and a computer-readable recording medium which records the program. A method for manufacturing glass fiber-reinforced thermoplastic resin composition pellets using a bi- or multi-axial extruder comprising screws which rotate to engage with each other, the method controlling a minimum value of time integration values of shearing stress (minimum shearing stress history value $T_{min}$), which is applied to glass fiber bundles when they are mixed and kneaded.

FIG. 3

EP 2 610 041 A1

**Description**

TECHNICAL FIELD

The present invention relates to a simulation device for deriving the manufacturing conditions of thermoplastic resin composition pellets, a program for realizing a function of this simulation device, and a computer readable recording medium which records this program.

BACKGROUND ART

As a method that mixes and kneads glass fiber into a thermoplastic resin to manufacture glass fiber-reinforced thermoplastic resin composition pellets, a method is common that supplies thermoplastic resin to an extruder, causes to melt, then supplies glass fiber, mixes and kneads the thermoplastic resin and glass fiber inside of the extruder, and cools and granulates the mixture. For the extruder, single screw extruders are co-rotation intermeshed twin screw extruders (hereinafter may be referred to as "twin screw extruder") are used; however, compared with a single screw extruder, a twin screw extruder has higher productivity and degree of freedom in operation, and thus a twin screw extruder is more preferably used.

In the manufacture of the above-mentioned glass fiber-reinforced thermoplastic resin composition pellets, for the glass fiber, either those obtained by making monofilaments having a diameter of 6 $\mu$m to 20 $\mu$m into one bundle together of about 300 to 3000, and wound into roving, or those obtained by cutting the roving at lengths of 1 to 4 mm (hereinafter may be referred to as "chopped strand") are used. In regards to handling, chopped glass is more convenient; therefore, when manufacturing glass fiber-reinforced thermoplastic resin composition pellets industrially, a method is most commonly carried out that supplies the thermoplastic resin to a twin screw extruder, and after melting the thermoplastic resin, supplies chopped glass from midstream of the twin screw extruder, mixes and kneads the molten thermoplastic resin and glass fiber, extrudes and then cools and solidifies the mixture.

The productivity of the glass fiber-reinforced thermoplastic resin composition pellets using the above-mentioned twin screw extruder is determined by the plasticizing and mixing/kneading abilities of the twin screw extruder. In addition to the screw design, the plasticizing ability of the twin screw extruder depends on the groove depth of screws (difference between external diameter and root diameter of screw), torque generated by the screw, and revolution speed. As shown in Patent Document 1, twin screw extruders have been developed having large groove depth, and high torque and revolution speed. The plasticizing ability of twin screw extruders has rapidly improved from this development. On the other hand, the mixing/kneading ability of twin screw extruders depends on the screw design. Since the retention time has decreased accompanying an improvement in the plasticizing ability of twin screw extruders, development of a screw design having mixing/kneading performance with good efficiency in a short time has been demanded.

As described above, chopped strands in which 300 to 3000 monofilaments have been made into a bundle are commonly used as the glass fibers. This is because, in a method that supplies glass fibers to the twin screw extruder without making into a bundle of monofilaments, the monofilaments will become flocculated, liquidity will be lost, and handling thereof will be difficult. The chopped strands are mixed and kneaded inside the twin screw extruder until broken down into monofilaments. Simultaneously, the chopped strands are broken until the length of the monofilaments becomes 300$\mu$m to 1000$\mu$m.

If the mixing and kneading inside of the twin screw extruder is insufficient, a part or all of the chopped strands, which are not broken down into monofilaments and in a state of a cluster of monofilaments, will remain in the resin composition pellets. In injection molding, if a part or all of the chopped strands remain in the glass fiber-reinforced thermoplastic resin composition pellets, a part or all of these chopped strands will clog the gate, and injection molding will not be possible, or even if injection molding is possible, a part or all of these chopped strands will be present in the molded article, thereby becoming a cause of appearance defects or functional decline.

The high-performance twin screw extruder of Patent Document 1 has come to be used in order to improve the productivity of glass fiber-reinforced thermoplastic resin composition pellets and to produce economically; however, when the productivity rises, it becomes much more difficult to completely break down the chopped strands into monofilaments with a short retention time, and thus technology that breaks down into monofilaments while maintaining high productivity has been demanded.

Technology for breaking down monofilaments can be obtained by repeated experimentation. However, a great deal of expense and time are required in the case of experiments using a twin-screw extruder.

However, a method of predicting resin behavior in a twin-screw extruder by simulation without conducting experiments using a twin-screw extruder has been developed. For example, if using software such as "Polyflow", "Ansys CFX" and "Fluent" by Ansys, or "ScrewFlow-Multi" by R-Flow Corp. Ltd., three-dimensional non-isothermal flow analysis in a twin-screw extruder is possible, and localized information such as viscosity, shearing speed, shearing stress and retention time in the twin-screw extruder can be calculated from simulation by further combining with particle trajectory analysis.

Patent Document 1: Japanese Unexamined Patent Application, Publication No. H11-512666

DISCLOSURE OF THE INVENTION

Problems to be Solved by the Invention

The present invention has been made in order to solve the above issues, and an object thereof is to provide a simulation device for deriving manufacturing conditions for enabling the break down of unbroken-down glass fiber bundles, which are clusters of monofilaments into monofilament, in the manufacture of a resin molded article using an engaging extruder of two screws or more, a program for realizing a function of this simulation device, and a computer readable recording medium which records this program.

Means for Solving the Problems

The present inventors have thoroughly researched in order to solve the above-mentioned issues.
As a result thereof, it was found that there is not a clear correlation between the pellet number N containing unbroken-down glass fiber bundles (number of pellets containing unbroken-down glass fiber bundles per unit weight) with any of an average shearing stress history, average shearing strain history, specific energy, minimum particle efflux time, etc., which are physical quantities obtained from numerical analysis, as will as finding that a minimum shearing stress history value $T_{min}$, which is the smallest value among time integration values of the shearing stress acting on each glass fiber bundle, has a correlation with the pellet number N containing unbroken-down glass fiber bundles.
In addition, it was found that, by controlling the minimum shearing stress history value $T_{min}$ in a case of analyzing the shearing stress generating in a twin-screw extruder, and the ratio of the discharged amount Q to the screw revolution speed Ns (Q/Ns) being constant, it is possible to control the pellet number N per unit amount containing unbroken-down glass fibers.
Furthermore, it was found that, even in a case of the above-mentioned ratio (Q/Ns) not being constant, the pellet number N per unit amount containing unbroken-down glass fibers can be expressed by a specific expression using the above-mentioned $T_{min}$ and (Q/Ns), thereby arriving at completing the present invention. More specifically, the present invention provides the following matters.

According to a first aspect of the present invention, in a simulation device for deriving a manufacturing condition that holds the number of pellets N containing glass fibers that are not broken down, per unit amount below a predetermined value when a thermoplastic resin and glass fiber bundles are kneaded in an extruder and thermoplastic resin composition pellets reinforced with glass fibers that are not broken down, are manufactured, the device includes: an inputting means for inputting information to derive the following expression (I); a manufacturing condition-calculating means for deriving the following expression (I) based on the information inputted into the inputting means, to calculate the manufacturing condition that the number of pellets reinforced with glass fibers that are not broken down, N, per unit amount, is below the predetermined value; and an outputting means for outputting the manufacturing condition calculated in the manufacturing condition-calculating means; in which the information inputted into the inputting means comprises multiple sets of: (L/D) which is a ratio between the length L of a screw element arranged in a portion for kneading the thermoplastic resin and the glass fiber bundles in the extruder and the external diameter (D) of the screw element; a discharged amount Q; a screw revolution speed Ns of the screw element; and a minimum shearing stress history value $T_{min}$ which is the smallest value among time integration values, on performing time integration of the number of pellets reinforced with glass fibers that are not broken down, N, per unit amount, and the shearing stress, which is applied to the glass fiber bundles in the extruder after the bundles are supplied to the extruder, with regard to the L/D, the discharged amount Q and the screw revolution speed Ns: [Math. 1]

$$N = 10^{\alpha} \left\{ \frac{T_{min}}{\left( \dfrac{Q}{Ns} \right)^{\gamma}} \right\}^{-\beta} \qquad (\text{I})$$

(in the above expression (I), all of $\alpha$, $\beta$, and $\gamma$ are constants more than 0).

According to a second aspect of the present invention, in the simulation device as described in the first aspect, the expression (I) is the following expression (II) when the external diameter of the screw element for kneading the thermoplastic resin and the glass fiber bundles is changed: [Math. 2]

$$N = 10^{\alpha} \left\{ \frac{T_{min}}{\left( \frac{(d2/d1)^{\delta} Q}{(d2/d1)^{-\varepsilon} Ns} \right)^{\gamma}} \right\}^{-\beta}$$

(II)

(in the above expression (II), d1 is the external diameter before the change, d2 is the external diameter after change, and all of $\alpha$, $\beta$, $\gamma$, $\delta$, and $\varepsilon$ are constants more than 0).

According to a third aspect of the present invention, in the simulation device as described in the first or second aspect, the manufacturing condition-calculating means includes: an approximate curve-creating step for creating an approximate curve which shows the relationship between the discharged amount Q and the minimum shearing stress history value $T_{min}$ with respect to each of a plurality of the L/D conditions; a threshold $T_{min}$-determining step for determining a threshold $T_{min}$, which is the minimum shearing stress history value $T_{min}$ at which the number of unbroken-down pellets N per unit amount is below the predetermined value, based on the expression (I); a discharged amount Qn-calculating step for calculating each discharged amount (Qn) with the threshold $T_{min}$ from each approximate curve; and a relational expression-deriving step for deriving a relational expression between the L/D and the Qn; in which the simulation device selects the manufacturing condition based on the relational expression.

According to a fourth aspect of the present invention, in the simulation device as described in any one of the first to third aspects, the screw element is a backward-feeding screw element which has a notch in a flight portion.

A fifth aspect of the present invention is a program for realizing the function of the simulation device as described in any one of the first to fourth aspects on a computer.

A sixth aspect of the present invention is a computer-readable recording medium which records the program as described in the fifth aspect. Effects of the Invention

According to the present invention, by controlling a minimum value of the time integration value of the shearing stress to which the glass fiber bundles are subjected during mixing and kneading of glass fiber bundles and thermoplastic resin (minimum shearing stress history value $T_{min}$), it is possible to derive the manufacturing conditions at which the glass fiber bundles are broken down into monofilaments by way of simulation.

It should be noted that, in a case of using a high-performance twin screw extruder excelling in production efficiency, a particular problem arises in that glass fiber bundles remain in the resin composition pellets without breaking down. The present invention can resolve the above-mentioned problem of glass fibers not breaking down, even if using such a high-performance twin screw extruder.

BRIEF DESCRIPTION OF THE DRAWINGS

FIG. 1 is a diagram showing an example of a screw configuration of an extruder;

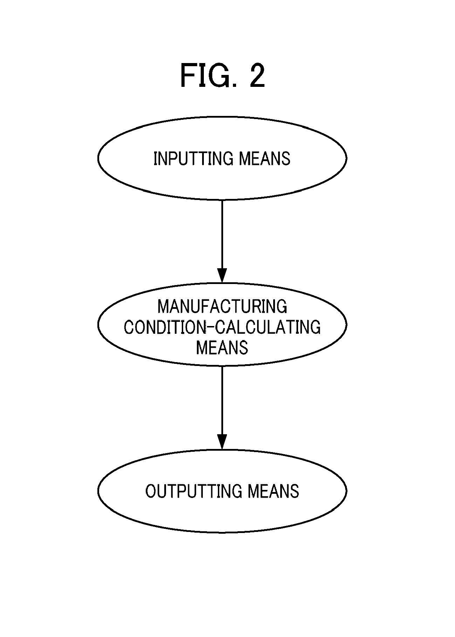

FIG. 2 is a block diagram showing an example of a simulation device of the present invention;
FIG. 3 is a flowchart showing an example of a simulation method;
FIG. 4 is a flowchart showing an example of a simulation method in a case of varying the extruder size;
FIG. 5 is a flowchart showing an example of a simulation method in which S2 differs from the flowchart shown in FIG. 3;
FIG. 6 provides graphs showing approximate curves expressing a relationship between a discharged amount Q and minimum shearing stress history value $T_{min}$ at each (L/D);
FIG. 7 provides graphs showing a linear function ((Q)=f(L/D)) expressing the relationship between L/D and Qn;
FIG. 8 is a diagram showing specific screw patterns employed in the examples;
FIG. 9 is a diagram showing specific screw shapes employed in the examples;
FIG. 10 is a graph showing a relationship between the minimum shearing stress history value (Pa·sec) and a pellet number (number/10 kg of pellets) for which a part or all of the glass fiber bundles are not broken down, under the condition of Q/Ns=1.0 for the extruder employed in the examples;
FIG. 11 is a graph showing a relationship (correlative line) between the minimum shearing stress history value (Pa·sec) and a pellet number (number/10 kg of pellets) for which a part or all of the glass fiber bundles are not broken down, under the conditions of Q/Ns=1.0, Q/Ns=0.8 and Q/Ns=0.5 for the extruder employed in the examples;

FIG. 12 is a graph showing a relationship (correlative line) between the minimum shearing stress history value (Pa·sec) and a pellet number (number/10 kg of pellets) for which a part or all of the glass fiber bundles are not broken down that is almost independent of Q/Ns of the extruder employed in the examples;

FIG. 13 provides graphs showing a relationship between the discharged amount and the minimum shearing stress history value of the extruder employed in the examples; and

FIG. 14 provides graphs showing a relationship between the discharged amount and L/D of the extruder employed in the examples.

PREFERRED MODE FOR CARRYING OUT THE INVENTION

Although embodiments of the present invention will be explained in detail hereinafter, the present invention is in no way limited to the following embodiments, and can be implemented by adding appropriate alterations within the scope of the object of the present invention. It should be noted that appropriate explanations may be omitted for passages for which explanations would be redundant; however, it is not to limit the gist of the invention.

A simulation device of the present invention derives the manufacturing conditions when manufacturing glass fiber-reinforced thermoplastic resin composition pellets by way of simulation. Prior to explaining the simulation device of the present invention, first, a method for manufacturing glass fiber-reinforced thermoplastic resin composition pellets will be briefly explained.

<Method for Manufacturing Glass Fiber-Reinforced Thermoplastic Resin Composition Pellets>

The method of manufacturing glass fiber-reinforced thermoplastic resin composition pellets is a method of manufacturing glass fiber-reinforced thermoplastic resin composition pellets using a bi- or multi-axial extruder comprising screws which rotate to engage with each other.

More specifically, the method of manufacturing glass fiber-reinforced thermoplastic resin composition pellets includes the following steps, for example.

A plasticizing step supplies thermoplastic resin to the above-mentioned extruder, then heats and kneads to plasticize. After the plasticizing step, a kneading step supplies at least one bundle of glass fibers to the extruder to break down the above glass fiber bundle, while kneading the broken-down glass fibers and the plasticized thermoplastic resin.

After the kneading step, an extrusion step extrudes a glass fiber-reinforced thermoplastic resin composition.

A pelletizing step pelletizes the extruded glass-fiber reinforced thermoplastic resin composition.

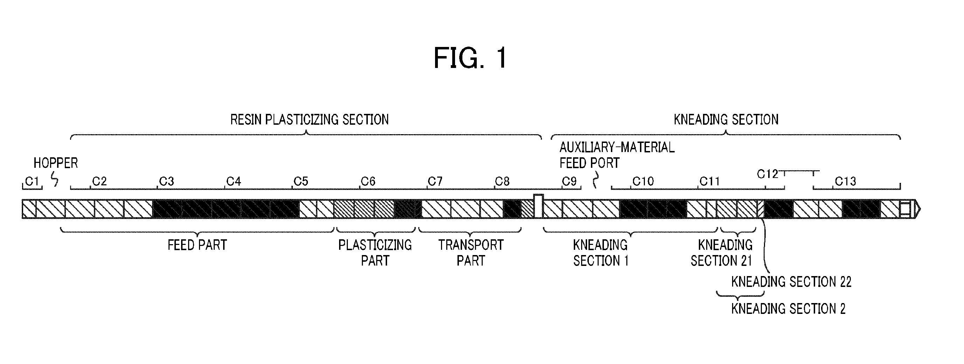

Hereinafter, each of these steps will be briefly explained. In the explanation, a twin-screw extruder equipped with the screw configuration illustrated in FIG. 1 will be used. This extruder includes a resin plasticizing section and a kneading section. The resin plasticizing section includes a feed part, plasticizing part and transport part, and the kneading section includes a kneading part 1 and a kneading part 2.

[Plasticizing Step]

In the plasticizing step, a homogeneous melt is made by transferring and melting the thermoplastic resin supplied from a hopper. First, the thermoplastic resin will be explained, and then, until the thermoplastic resin supplied from the hopper becomes the homogeneous melt will be explained (details of plasticizing step).

(Thermoplastic Resin)

The type of thermoplastic resin used is not particularly limited. As specific examples of the thermoplastic resin, polypropylene, polyacetal, liquid crystal resin, polybutylene terephthalate, polyethylene terephthalate, polyphenylene sulfide, nylon 66, etc. can be exemplified. Among these thermoplastic resins, problems of unbroken-down fibers of the above-mentioned glass fiber bundles tend to occur more particularly with those having lower viscosity. This is because, if the viscosity is low, shearing stress is hardly generated in the melted state, and thus the glass fiber bundles in which monofilaments are bundled are hardly broken down. As a low-viscosity resin, for example, liquid crystal resin, polyethylene terephthalate, nylon 66, etc. can be exemplified.

(Details of Plasticizing Step)

Plasticizing of the thermoplastic resin is performed in the resin plasticizing section of the twin screw extruder illustrated in FIG. 1. The resin plasticizing section has a feed part, plasticizing part, and transport part. As the screw elements used in the feed part and transport part, for example, an element for conveyance consisting of forward flights or the like can be exemplified, for example. As the screw elements used in the plasticizing part, a combination of screw elements such as a reverse flight, sealing, sequential kneading disks and reverse kneading disk or the like can be exemplified. Hereinafter, the feed part, plasticizing part and transport part will be briefly explained.

Resin pellets are transferred in the feed part. The feed part makes an operation to transfer resin pellets from a hopper side to a die direction side, at a temperature setting such that the resin pellets generally do not melt. Although it is performed at a low temperature such that the resin pellets do not melt in this way, preheating may be performed by an external heater as a melt preparation stage. In addition, the resin pellets are interposed between the rotating screws and the cylinders; therefore, friction force acts on the resin pellets, whereby frictional heat generates. Melting may also be started by the above-mentioned preheating and frictional heat.

Depending on the case, it is necessary to perform adjustment of the groove depth of the screw and temperature adjustment for preheating by a conventional, known method, so that the transfer of resin pellets smoothly advances in the feed part.

In the plasticizing part, the resin pellets are melted by applying pressure to the resin pellets transferred from the feed part. In the plasticizing part, shearing stress acts on the resin pellets, a result of which the resin pellets melt while being transferred further forward (direction of die from hopper).

In the transport part, the thermoplastic resin melted in the plasticizing part (hereinafter may be referred to as molten resin) is transferred. The transport part transfers the thermoplastic resin having entered a homogeneous melted state by the plasticizing part to the kneading part.

<Kneading Step>

In the kneading step, glass fiber bundles of at least one bundle are supplied to the extruder after the plasticizing step, and the above-mentioned glass fiber bundles are broken down, while kneading the broken-down glass fibers and the plasticized thermoplastic resin.

The kneading step is performed in the kneading section of the twin screw extruder illustrated in FIG. 1. The kneading section consists of a kneading part 1 and a kneading part 2, where the kneading part 2 consists of a kneading portion 21 and a kneading portion 22. As the screw elements used in the kneading part 1, elements for conveyance consisting of forward-feeding flights can be exemplified, for example. As the screw elements used in the kneading portions 21 and 22, a combination of screw elements such as a backward-feeding flight, sealing, a forward-feeding kneading disk and a backward-feeding kneading disk or the like can be exemplified. For example, a combination such as using forward-feeding kneading disks in the kneading portion 21, and using a backward-feeding flight in the kneading portion 22 can be exemplified. In addition, as described later, in the method for manufacturing of the present invention, it is preferable to use a backward-feeding screw element having notches in the flight part in the kneading portion 21 (In the present embodiment, the kneading portion 21 is a backward-feeding screw element having notches in the flight portion).

(Kneading Part 1)

In the kneading part 1, the glass fiber bundles charged from an auxiliary-material feed port and molten resin are conveyed to the kneading part 2. In the conveyance of this kneading part 1, the glass fiber bundles and resin are not completely filled inside of the screw grooves, but is a region in which the shearing stress does not act on the glass fiber bundles.

The glass fiber bundles will be explained briefly. As the glass fiber bundles, chopped strands in which 300 to 3000 monofilaments make a bundle, and chopped strands in which 1100 to 2200 make a bundle are preferably used. In addition, the diameter of the monofilaments is not particularly limited; however, those in the range of 6 $\mu$m to 20 $\mu$m are preferable, and those of 6 $\mu$m, 10 $\mu$m and 13 $\mu$m are particularly preferable in physical properties. It should be noted that the bundles of monofilaments still as roving can be supplied continuously to the twin screw extruder. However, the chopped strands formed by cutting the roving are easily handled in transport and supply to the twin screw extruder. For this reason, it is preferable to use chopped strands.

(Kneading Part 2)

In kneading part 2, the shearing stress acts on the glass fiber bundles and molten resin. The break down of glass fiber bundles and the kneading of monofilaments with the molten resin progress from the shearing stress acting. Herein, the screw revolution speed in the kneading part 2 is the revolution speed Ns. In addition, the screw length of the kneading portion 21 is L, and the screw external diameter is D.

A characteristic of the method of manufacturing according to the invention of the present application is that, as a result of kneading of the glass fiber bundles and molten resin in the kneading part 2, almost no unbroken-down glass fiber bundles remain in the pellets. In order to obtain this effect, it is necessary to perform manufacturing of resin composition pellets at specific manufacturing conditions. The present invention is a simulation device for deriving these specific manufacturing conditions.

(Extrusion Step, Pelletizing Step)

Although how the glass fiber-reinforced thermoplastic resin composition is extruded, and how it is pelletized are not particularly limited, for example, it is possible to pelletize by cutting a glass fiber-reinforced thermoplastic resin composition that had been extruded into rod form. It should be noted that the cutting method is not particularly limited, and a conventional, known method can be employed. It should be noted that the discharged amount in the extrusion step is a discharged amount Q.

<Simulation Device>

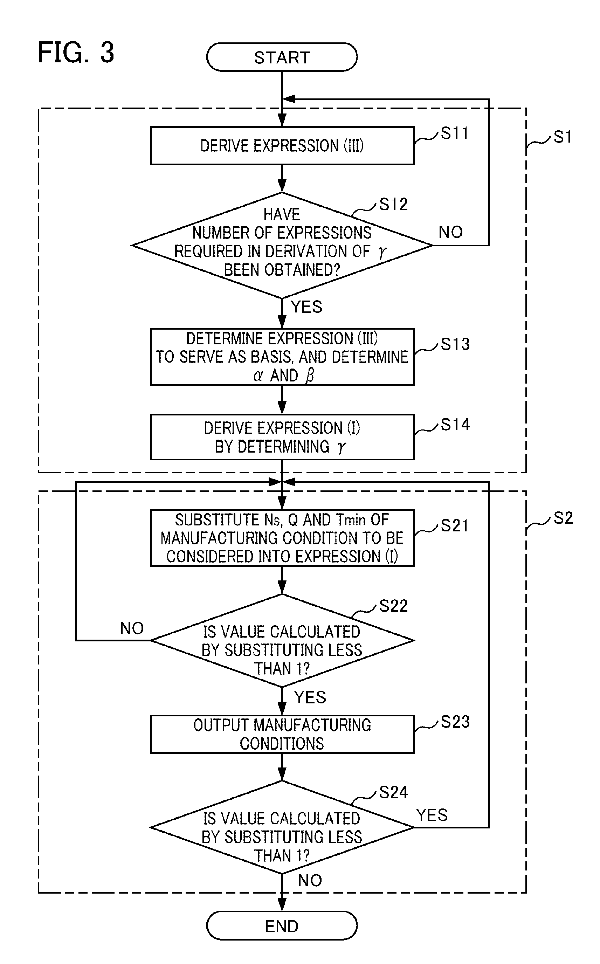

The simulation device of the present invention includes an inputting means, a manufacturing condition-calculating means, and an outputting means.
At the inputting means, a plurality of sets of the screw revolution speed Ns (L/D, discharged amount Q, and screw revolution speed Ns may collectively be referred to as "derivation conditions of minimum shearing stress history value"), unbroken-down pellet number N, minimum shearing stress history value $T_{min}$ are input.
ased on the derivation conditions of the minimum shearing stress history value, minimum shearing stress history value $T_{min}$ and unbroken-down pellet number N per unit amount inputted, the manufacturing condition-calculating means derives the above-mentioned expression (I) and calculates manufacturing conditions at which the unbroken-down pellet number N is less than a predetermined value. In the present embodiment, a case of the unbroken-down pellet number N per 1 kg being less than 1 will be explained.
The manufacturing conditions calculated by the manufacturing condition-calculating means are outputted by the outputting means.
First, each parameter inputted to the inputting means will be explained. It should be noted that L, D, discharged amount Q, and screw revolution speed Ns are as described above, and thus explanations will be omitted.
The minimum shearing stress history value $T_{min}$ can be derived using conventional, known three-dimensional flow in twin-screw extruder analysis software. For example, it can be derived by particle trajectory analysis as described in the Examples. The minimum shearing stress history value $T_{min}$ is a time-integrated value obtained by performing time integration of the shearing stress; however, the integral interval is an interval in which the shearing stress acts on the molten resin and glass fiber bundles, and in the case of the extruder illustrated in FIG. 1, is the interval of the kneading part 2.
The derivation method of the minimum shearing stress history value is not particularly limited. A method of deriving using commercial software, a method of deriving by experimentation, and the like can be exemplified.
Hereinafter, operations of the simulation device and the simulation method of the present invention will be explained based on the flowchart of FIG. 3.
The following expression (I) is derived based on inputted information (derivation conditions of minimum shearing stress history value, unbroken-down pellet number per unit amount, and minimum shearing stress history value) (S1).
[Math. 3]

$$N = 10^{\alpha} \left\{ \frac{T_{min}}{\left( \dfrac{Q}{Ns} \right)^{\gamma}} \right\}^{-\beta} \qquad (\text{I})$$

Upon derivation of the expression (I), when preparing a two-dimensional graph with the horizontal axis defined as N and the vertical axis defined as $T_{min}$, the constant $\gamma$ is determined so that the influence of Q/Ns is reduced.
Although $\alpha$, $\beta$ and $\gamma$ may be derived by any method, for example, it is possible to derive by the following method.
Initially, the following expression (III) is derived based on input data of the conditions of a predetermined Q/Ns (S11). [Math. 4]

$$N = 10^{\alpha} \mathrm{T_{min}}^{-\beta} \qquad\qquad \mathrm{(III)}$$

(In the above expression (I), $\alpha$ and $\beta$ are constants of at least 0.)

$\alpha$ and $\beta$ are determined based on the expression (III) derived.

The derivation of the expression (III) is repeated changing the conditions of predetermined Q/Ns to different conditions until reaching the number of expressions (III) necessary in order to derive $\gamma$ (S12). It should be noted that the number of conditions of Q/Ns necessary in order to derive $\gamma$ is decided and set in advance. The number of expressions is preferably at least 3.

Next, the expression (III) to serve as a basis is determined from among the plurality of expressions (III) obtained, and $\alpha$ and $\beta$ are determined (S13). The selection method is not particularly limited, and can be arbitrarily determined. For example, the initially derived expression (III) can be set as the basis. The $\alpha$ and $\beta$ of this expression (III) serving as the basis become the $\alpha$ and $\beta$ of expression (I).

The $\gamma$ for unifying the expressions (III) differing according to the condition of Q/Ns into one expression is derived (S14). The value of $\gamma$ that can be adopted irrespective of the condition of Q/Ns is determined using a conventional, known approximation method (for example, methods like the least-squares method, Gauss-Newton method, simplex method, etc.)

The manufacturing conditions such that N is less than a predetermined number are derived (S2). It ends by the calculation result of the manufacturing conditions being outputted by the outputting means. The calculation of the manufacturing conditions can be carried out by the following method, for example.

Ns, Q and $T_{min}$ of the manufacturing conditions to be considered are substituted into the derived expression (I) and calculation is performed (S21). The Ns, Q and $T_{min}$ of the manufacturing conditions to be considered may be determined by being arbitrarily selected automatically by computer, or may be set so as to substitute Ns, Q and $T_{min}$ determined in advance. Calculation of the manufacturing conditions may be performed by fixing at least one among Ns, Q, $T_{min}$ and Q/Ns.

As the calculated result, in the case of N being at least a predetermined number (1 in the present embodiment), predetermined Ns, Q and $T_{min}$ are changed to conditions at which $T_{min}$ is greater, or Q/Ns is smaller, and these values are substituted into expression (I) (S22). It may be set in advance how to change the conditions in the case of N being at least this.

If the condition of N is less than a predetermined number (e.g., less than 1), the manufacturing conditions will be output by the outputting means (S23).

The calculation of manufacturing conditions is repeated until manufacturing conditions at which N is less than a predetermined number are obtained a number of times decided in advance (S24). The number of manufacturing conditions calculated is determined arbitrarily. When the desired number of manufacturing conditions have been obtained, the simulation ends.

It should be noted that, if the type of thermoplastic resin and the type of glass fiber bundles differ, it will be necessary to derive a new expression (I). Then, in the case of using an expression (I) derived in advance, after inputting the derivation conditions of the minimum shearing stress history value, number of unbroken-down pellets, and minimum shearing stress history value, if only the calculation of the manufacturing conditions such that N becomes less than a predetermined number (S2) is carried out, it will be possible to calculate the manufacturing conditions.

(Determination of Manufacturing Conditions when Changing Extruder Size)

Generally, consideration of the manufacturing conditions is done using a small-scale prototype, and the manufacturing of the resin composition pellets is performed with large-scale mass-production equipment. When performing manufacturing with this mass-production equipment, if using the relational expression (I) derived using a small-scale prototype, it will not be possible to accurately select manufacturing conditions such that the unbroken-down pellet number per unit amount is less than a predetermined value. This is because, even if conditions of the same discharged amount and the same screw revolution speed, the transmitted thermal energy from the barrel will differ between the small-scale prototype and the large-scale mass-production equipment, and thus the thermal energy acting on the molten resin will differ.

Although it is possible to perform simulation, experimentation, etc. not with the small-scale prototype, but rather with the large-scale mass-production equipment to derive the above-mentioned expression (I) for the large-scale mass-production equipment by a method similar to the aforementioned method, time, cost and labor is required. By performing the method explained hereinafter, it is possible to derive the expression (II) that can be used with large-scale mass-production equipment from the expression (I) derived with a small-scale prototype.

In a case of making a change in the external diameter D of the screw element from d1 to d2, the following expression (IV) is established between the discharged amount $Q_m$ of the prototype and the discharged amount $Q_M$ of the mass-production equipment, and the following expression (V) is established between the screw revolution speed $Ns_m$ of the prototype and the screw revolution speed $Ns_M$ of the mass-production equipment. [Math. 5]

$$Q_M = \left(\frac{d2}{d1}\right)^{\delta} Q_m \qquad (IV)$$

[Math. 6]

$$Ns_M = \left(\frac{d2}{d1}\right)^{-\varepsilon} Ns_m \qquad (V)$$

$\delta$ and $\varepsilon$ in the above expressions (IV) and (V) are determined so that the specific energy acting on the molten resin is equal. The determination method of $\delta$ and $\varepsilon$ may be either a theoretical determining method or an experimental determining method. Generally, as the theoretical determining method, by assuming a thermally insulated state, the parameters $\delta$ and $\varepsilon$ are derived so that the specific energy, or total shear amount, retention time, etc. as the objective function match between the small-scale equipment and large-scale equipment. Assuming a difference in transmitted thermal energy between the small-scale equipment and large-scale equipment, it is also possible to derive the parameters $\delta$ and $\varepsilon$ so that the specific energy as the objective function matches between the small-scale equipment and large-scale equipment. As the experimental determining method, a method that defines the objective function as the specific energy, or adopts a parameter indicating a physical property, and statistically calculates the parameters $\delta$ and $\varepsilon$ so that the objective function matches between the small-scale equipment and large-scale equipment can be exemplified.

By deriving the above expressions (IV) and (V) established between the small-scale prototype and the large-scale mass-production equipment, it is possible to easily derive the following expression (II) between the unbroken-down pellet number N per unit amount and minimum shearing stress history value $T_{min}$ established for the large-scale equipment.

[Math. 7]

$$N = 10^{\alpha} \left\{ \frac{T_{min}}{\left[\frac{(d2/d1)^{\delta} Q}{(d2/d1)^{-\varepsilon} Ns}\right]^{\gamma}} \right\}^{-\beta} \qquad (II)$$

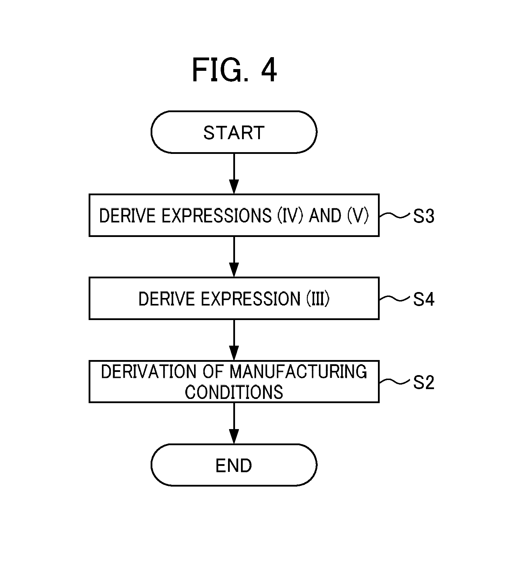

Next, the operations of the simulation device and simulation method of the present invention in the case of varying the extruder size will be explained based on the flowchart of FIG. 4.

Simulation is started by inputting the value of d2 to the inputting means. It should be noted, in the case of deriving $\delta$ and $\varepsilon$ in the above expressions (IV) and (V) by experimentation, these values derived by experimentation are also input (in the case of experimentally deriving, the below step S3 is omitted.).

First, $\delta$ and of the above expressions (IV) and (V) are derived (S3). By assuming a thermally insulated state, these values are derived so that the specific energy, or total shear amount, retention time, etc. as the objective function match between the small-scale equipment and large-scale equipment.

Next, the expression (II) is derived (S4). After derivation of the expression (II), since it is possible to derive the manufacturing conditions in a similar manner to the aforementioned method (S2), explanation will be omitted.

(Simple Determination Method of Manufacturing Conditions)

It is possible to determine the manufacturing conditions such that resin composition pellets containing unbroken-down glass fiber bundles are not manufactured, by using the above such expressions (I) and (II). However, in the case of a method substituting Ns, Q and $T_{min}$ in the expression (I) or (II) whenever considering manufacturing conditions, a great deal of time is required (time is particularly required in the derivation of $T_{min}$ by simulation). Therefore, by deriving a relationship between the length L/D and a discharged amount that is the maximum among those permitted (maximum discharged amount) by the following method, it is possible to easily determine the manufacturing conditions based on this relationship. As a result thereof, it is possible to determine manufacturing conditions satisfying the condition of N being less than a predetermined value. More specifically, following aforementioned S1, S2 is implemented by the following method.

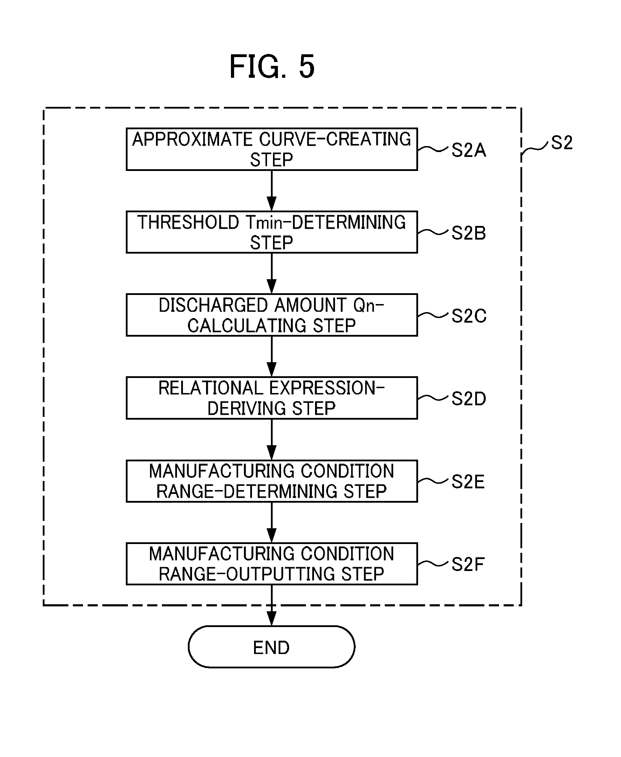

The method of deriving the relationship between the length L/D and maximum discharged amount explained below includes an approximate curve-creating step (S2A), approximate curve threshold $T_{min}$-determining step (S2B), discharged amount Qn-calculating step (S2C), and relational expression-deriving step (S2D). Then, based on the relational expression obtained in the relational expression-deriving step (S2D), a manufacturing condition range-determining step (S2E) to determine the range of selectable manufacturing conditions, and a manufacturing condition range-outputting step to output the manufacturing condition range are performed, and the simulation ends. Hereinafter, each step will be explained in detail. The flowchart illustrated in FIG. 5 is used in the explanation.

(Approximate Curve-Creating Step (S2A))

In the approximate curve-creating step, Q/Ns=constant is established, and an approximate curve expressing the relationship between the discharged amount Q and the minimum shearing stress history value $T_{min}$ is created.

More specifically, it is possible to create an approximate curve based on (L(length of kneading portion 21)/D), discharged amount Q, screw revolution speed Ns and minimum shearing stress history value $T_{min}$ inputted to the inputting means in S1, for example.

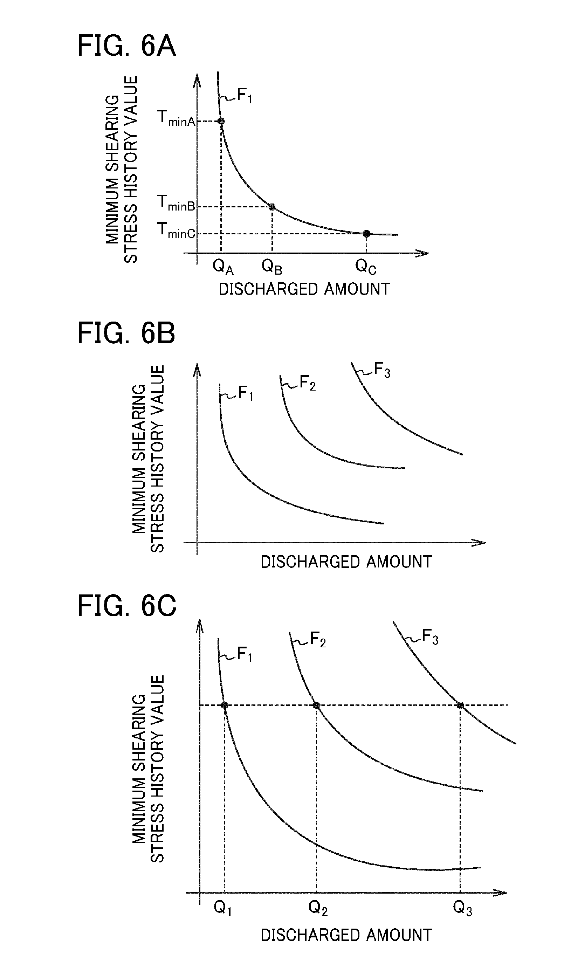

For example, the approximate curve is created from $(Q_A, T_{minA})$, $(Q_B, T_{minB})$ and $(Q_C, T_{minC})$, which are inputted conditions. For example, although the method of creating an approximate curve is not particularly limited, it can be created by a method like the least-squares method, Gauss-Newton method, and simplex method. It should be noted that an approximate curve F1 is shown in FIG. 6(a).

In addition, in the approximate curve-creating step (S2A), an approximate curve representing the relationship between the discharged amount Q and the minimum shearing stress history value $T_{min}$ at each (L/D) is created by changing the conditions of the length (L) of the kneading portion 21/external diameter (D) of screw element (L/D) at least once, by a method similar to that described above. It should be noted that the lead length (L) indicates the lead length of a kneading disk for breaking down glass fiber bundles, while kneading broken-down glass fibers and plasticized thermoplastic resin (kneading portion 21) .

In the approximate curve-creating step (S2A), although it is sufficient to derive the approximate curve at least once, herein, it is configured to derive approximate curves F2 and F3. The approximate curves F1, F2 and F3 are shown in FIG. 6(b).

(Threshold $T_{min}$-Determining Step (S2B))

Threshold $T_{min}$-determining step is a step of determining the minimum shearing stress history value $T_{min}$ at which the pellet number N in the above-mentioned formula (I) becomes less than a predetermined value (set as 1 in the present embodiment). The minimum shearing stress history value $T_{min}$ can be derived by creating a graph in which the unbroken-down pellet number N is the vertical axis, and the minimum shearing stress history value $T_{min}$ is the horizontal axis.

(Discharged Amount Qn-Calculating Step (S2C))

The discharged amount Qn-calculating step is a step of calculating each discharged amount (Qn) for the threshold $T_{min}$ from the respective approximate curves created.

The discharged amount calculated by substituting the threshold $T_{min}$ in the approximate curve F1 is defined as Q1, the discharged amount calculated by substituting the threshold $T_{min}$ in the approximate curve F2 is defined as Q2, and the discharged amount calculated by substituting the threshold $T_{min}$ in the approximate curve F3 is defined as Q3. Q1, Q2 and Q3 are shown in FIG. 6(c).

(Relational Expression-Deriving Step (S2D))

The relational expression-deriving step is a step of approximating the relationship between the above-mentioned L/D and Qn from the L/D and each of the above-mentioned discharged amounts (Qn) in the respective approximate curves, according to a linear function ((Q) = f(L/D)).

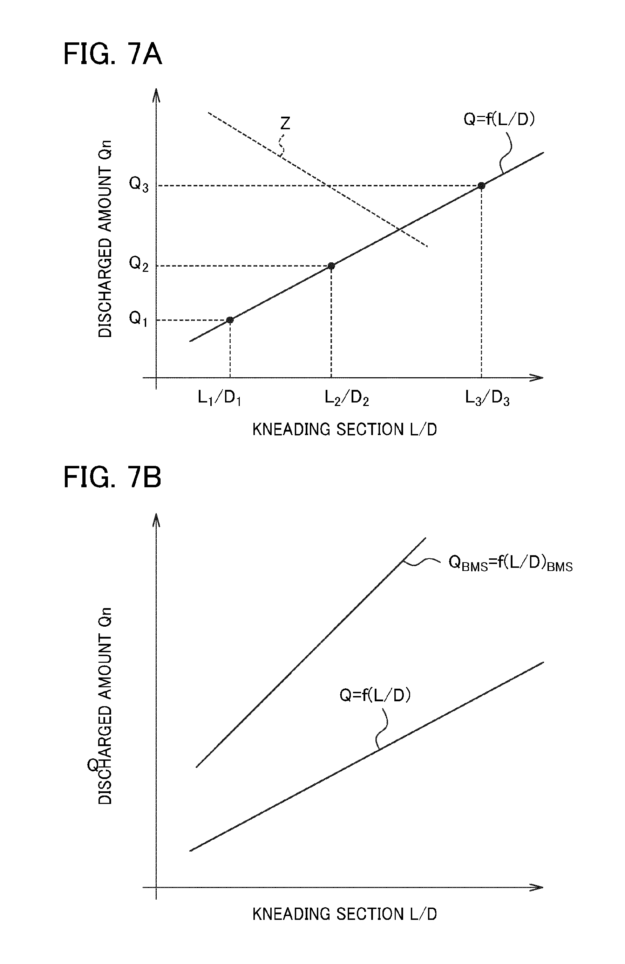

When deriving the discharged amount Q1, L/D is defined as L1/D1, the above-mentioned L/D when deriving the discharged amount Q2 is defined as L2/D2, and the above-mentioned L/D when deriving the discharged amount Q3 is defined as L3/D3. The kneading section L/D is defined as the horizontal axis and the discharged amount Q is defined as the vertical axis, and the linear function ((Q)=f (L/D)) is derived from (Q1, L1/D1), (Q2, L2/D2) and (Q3, L3/D3). The derived results are shown in FIG. 7(a). It should be noted that, although the derivation method is not particularly limited, it can be derived by a method such as the least squares method, for example.

The relationship between L/D and the maximum discharged amount is derived in the above way. The extruding conditions can be easily determined by performing the following manufacturing condition-determining step based on this relationship. For example, the manufacturing conditions can be determined by performing the manufacturing condition range-determining step (S2E) and the manufacturing condition range-outputting step (S2F).

(Manufacturing Condition Range-Determining Step (S2E))

In the manufacturing condition range-determining step, the manufacturing condition range for which the pellet number per unit amount in which unbroken-down glass fibers are contained is less than a predetermined value is determined. More specifically, a region satisfying (Q)<f(L/D) is determined. So long as selecting manufacturing conditions from this region, the minimum shearing stress history value $T_{min}$ will be at least the threshold $T_{min}$, and the pellet number per unit amount containing unbroken-down glass fiber bundles will be less than a predetermined value.

(Manufacturing Condition Range-Outputting Step (S2F))

The manufacturing condition range-outputting step (S2F) is a step of outputting, by way of the outputting means, the manufacturing condition range determined in the above-mentioned manufacturing condition range-determining step (S2E). Since the desired manufacturing conditions are obtained from this output, the simulation ends.

In addition, it is necessary to maintain the resin temperature inside of the extruder to no higher than a temperature at which the resin degrades. The dotted line Z in FIG. 7(a) is a line indicating the temperature of the resin degradation boundary. The discharged amount can be raised until the intersection of (Q)=f(L/D) with this. Particularly in the case of a resin that tends to degrade with heat, a line indicating the temperature of the resin degradation boundary is considered in the manufacturing condition range-determining step (S2E), so that the resin does not degrade, for example.

It should be noted that, if the expression (II) is used in place of the expression (I), it is possible to perform the above-mentioned simple determination of manufacturing conditions for the case of large-scale mass-production equipment.

In addition, (Q)BMS=f(L/D)BMS in the case of using a screw element having notches such as that described in Japanese Unexamined Patent Application, Publication No. 2002-120271 in the kneading part 2 is shown in FIG. 7(b). It is preferable due to the range of selection of manufacturing conditions widening by using screw elements having notches.

EXAMPLES

Hereinafter, the present invention will be specifically explained illustrating Examples and Comparative Examples; however, the present invention is not to be limited to these Examples.

The following materials were used in the Examples. Thermoplastic resin: polybutylene terephthalate resin (PBT) (melt index (MI) = 70 g/ 10 min)
Carbon master batch
Glass fiber bundles: 3 mm-long chopped strands in which 2,200 monofilaments with a 13μm-diameter were bundled
In addition, the composition was as follows.
67.5% by mass PBT, 2.5% by mass carbon master batch, 30% by mass glass fiber bundles
The extruding conditions were as follows.
Extruder: co-rotation intermeshed twin screw extruder TEX44αII (The Japan Steel Works, Ltd.); screw element external diameter (D): 0.047 m
Extruding Conditions:

[Table 1]

| Discharged amount Q[kg/hr] | 100 | 300 | 650 |
|---|---|---|---|
| Q/Ns [kg/hr/rpm] | 0.5, 0.8, 1.0 | | |
| Barrel temperature: 220°C Screw design: | | | |

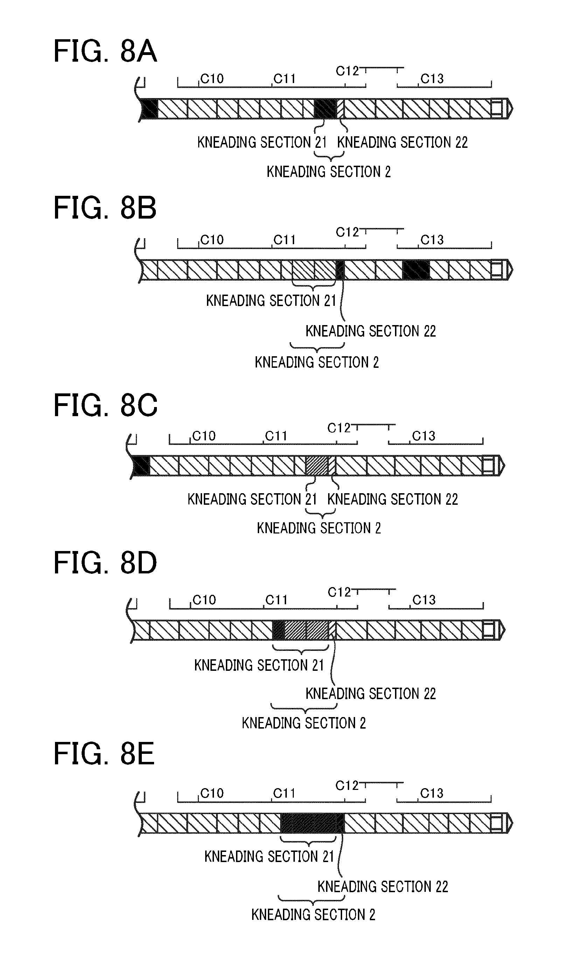

(1) Outline
The screw of the extruder can be represented as in FIG. 1, and an outline of the screw pattern shown in FIG. 1 is as follows. C1: hopper
C2 to C5: feed part
C5 to C6: plasticizing part
C6 to C8: transport part
C9: auxiliary-material feed port
C10: kneading part 1
C11: kneading part 2 (consisting of kneading portion 21 and kneading portion 22)
(2) The specific screw pattern used in the Examples is as shown in FIG. 8. It should be noted that, for the kneading disks, those in which each disk has a phase shifted 45° in the feeding direction are defined as FK, and elements having notches in the backward-feeding single-thread flight are defined as BMS. The screw pattern shown in FIG. 8(a) is defined as FK1.0D (L/D=1),
the screw pattern shown in FIG. 8(b) is defined as FK2.0D (L/D=2),
the screw pattern shown in FIG. 8(c) is defined as BMS1.0D (L/D=1),
the screw pattern shown in FIG. 8(d) is defined as BMS2.0D (L/D=2), and
the screw pattern shown in FIG. 8(e) is defined as BMS2.5D (L/D=2.5).
L/D is a ratio (L/D) of the lead length (L) of the kneading portion 21 to the external diameter (D) of the screw element.
(3) Shape of Screws

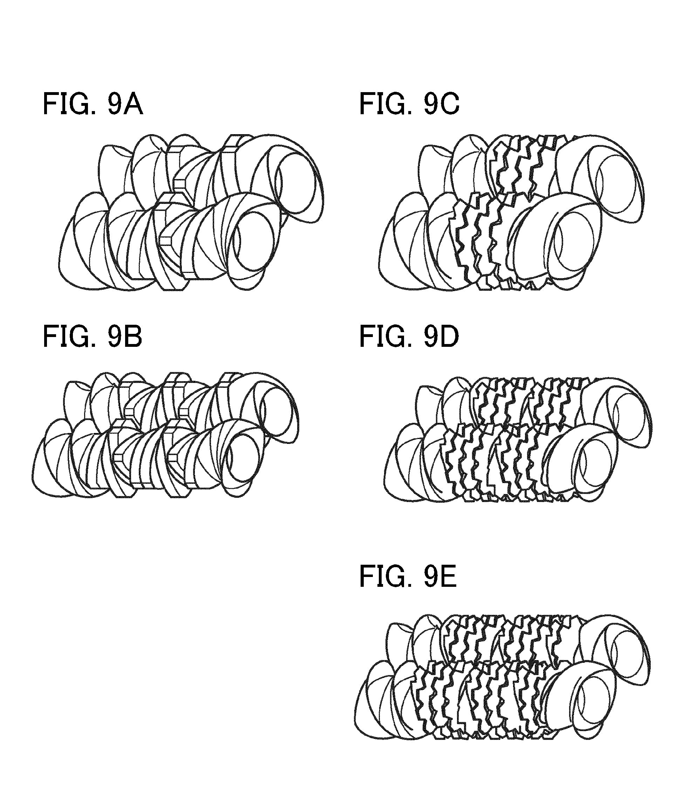

The screw patterns shown in FIG. 8 only differ from each other in the kneading part 2 of C11. The shapes of the screws in the kneading part 2 of C11 are shown in FIG. 9. The screw shape of the pattern in FIG. 8(a) is shown in FIG. 9(a), the screw shape of the pattern in FIG. 8(b) is shown in FIG. 9(b), the screw shape of the pattern in FIG. 8(c) is shown in FIG. 9(c), the screw shape of the pattern in FIG. 8(d) is shown in FIG. 9(d), and the screw shape of the pattern in FIG. 8(e) is shown in FIG. 9(e).
In the screws shown in FIG. 9(a), the kneading portion 21 is a forward-feeding kneading disk with a length of 1.0D, and the kneading portion 22 is a backward-feeding flight with a length of 0.5D.
In the screws shown in FIG. 9(b), the kneading portion 21 is a forward-feeding kneading disk with a length of 2.0D, and the kneading portion 22 is a backward-feeding flight with a length of 0.5D.
In the screws shown in FIG. 9(c), the kneading portion 21 is a single-thread backward-feeding kneading disk with notches having a length of 1.0D, and the kneading portion 22 is a backward-feeding flight with a length of 0.5D.
In the screws shown in FIG. 9(d), the kneading portion 21 is single-thread backward-feeding kneading disk with notches having a length of 2.0D, and the kneading portion 22 is a backward-feeding flight with a length of 0.5D
In the screws shown in FIG. 9(e), the kneading portion 21 is a single-thread backward-feeding kneading disk with notches having a length of 2.5D, and the kneading portion 22 is a backward-feeding flight with a length of 0.5D

(Derivation of Expression (III))

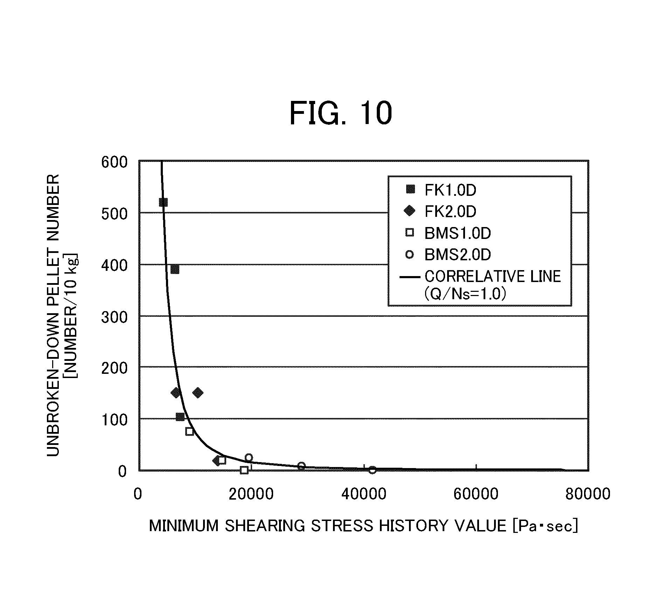

The relationships between the minimum shearing stress history value (Pa·sec) and the pellet number (number/ 100 kg of pellets) for which a part or all of the glass fiber bundles are not broken down such as shown in FIG. 10 were obtained under the condition of Q/Ns=1.0. They were specifically derived by the following such method.
First, a plurality of sets of L/D, discharged amount Q, screw revolution speed Ns, unbroken-down pellet number N, and minimum shearing stress history value $T_{min}$ necessary in the derivation of the expression (III) are determined. The L/D, discharged amount Q and screw revolution speed Ns are decided arbitrarily to derive the minimum shearing stress history value by the following method, and the unbroken-down pellet number N is obtained from experimentation. They were specifically obtained as follows.
First, derivation of the minimum shearing stress history value (Pa·sec) by simulation will be explained.
The resin behavior inside of a co-rotation intermeshed twin screw extruder was analyzed using three-dimensional flow in twin screw extruder analysis software (ScrewFlow-Multi made by R-Flow Corp., Ltd.).
The governing equations used upon analysis are a continuity equation (A), Navier-Stokes equation (B), and temperature balance equation (C).
[Math. 8]

$$\frac{\partial \rho}{\partial t} + \nabla \cdot \vec{v} = 0$$

$$(A)$$

[Math. 9]

$$-\nabla p + \nabla \cdot \vec{\tau} = 0 \qquad \text{(B)}$$

[Math. 10]

$$\frac{\partial T}{\partial t} + \rho C_p \vec{v} \cdot \nabla T = k \nabla^2 T + Q \qquad \text{(C)}$$

Complete melting and complete filling with an incompressible fluid were defined as analysis assumptions. In addition, the viscosity approximation used Arrhenius approximation and WLF approximation. The analysis technique was a finite volume method, SOR method, and SIMPLE algorithm, and as operations, first steady-state analysis was performed, and then unsteady analysis was performed with this as an initial value. After the unsteady analysis, tracer particles were arranged (about 5,000), and local information according to the tracer particles was collected (particle tracking analysis). The minimum value $T_{min}$ for the time-integrated value of shearing stress is a value obtained by time integrating the shearing stress of local information according to the tracer particles, and taking the minimum value of all particles.

Next, derivation of the unbroken-down pellet number from experimentation will be explained.
After supplying PBT to the twin screw extruder, chopped strands of glass were supplied under the above-mentioned extruding conditions to be kneaded and mixed, and then the resin composition was extruded from the die and the molten resin composition was withdrawn from the die to make a strand, the strand was cooled and solidified in a water tank, and then the strand was cut to lengths of 3 mm by a cutter, thereby creating pellets. Ten kilograms of pellets were collected, unbroken-down glass in black pellets (silver aggregates) were searched for visually, and the number of pellets containing unbroken-down glass was counted.

Approximate curves expressing the relationship between the unbroken-down pellet number and the minimum shearing stress history value (correlative line) were obtained by the least-squares method. At Q/Ns=1.0, the different elements of FIG. 8(a) to (e) as described above were inserted in the kneading part 2, and experiments and simulations were performed at different Q, a result of which the following one approximate curve was obtained. The approximate curve is shown in FIG. 10.

[Math. 11]

$$N = 10^{11.5042} \, T_{min}^{-2.200} \qquad \text{(VII)}$$

In other words, in the above mathematical expression (III), $\alpha$ was 11.5042 and $\beta$ was -2.200.

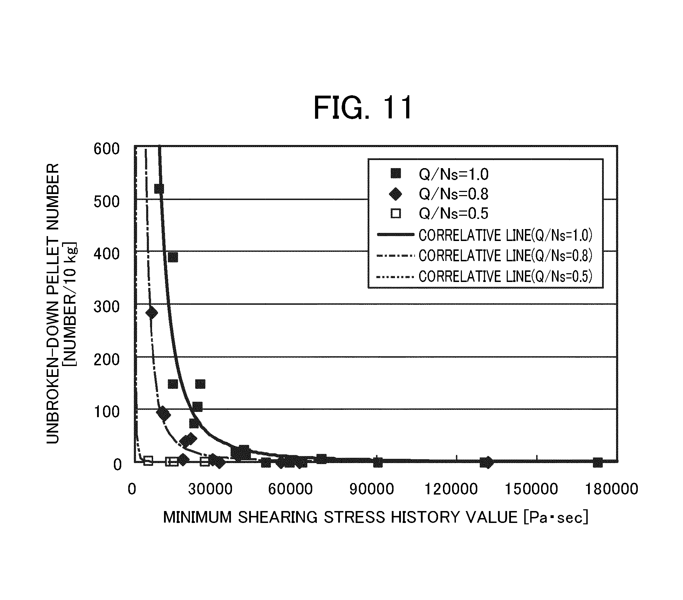

Similarly to as described above, the relationships between the minimum shearing stress history value (Pa·sec) and the pellet number for which a part or all of the glass fiber bundles are not broken down (correlative line) were obtained also at conditions of Q/Ns=0.8 and Q/Ns=0.5 as shown in FIG. 11. It should be noted that the correlative line for the case of Q/Ns=1.0 is shown in FIG. 11.

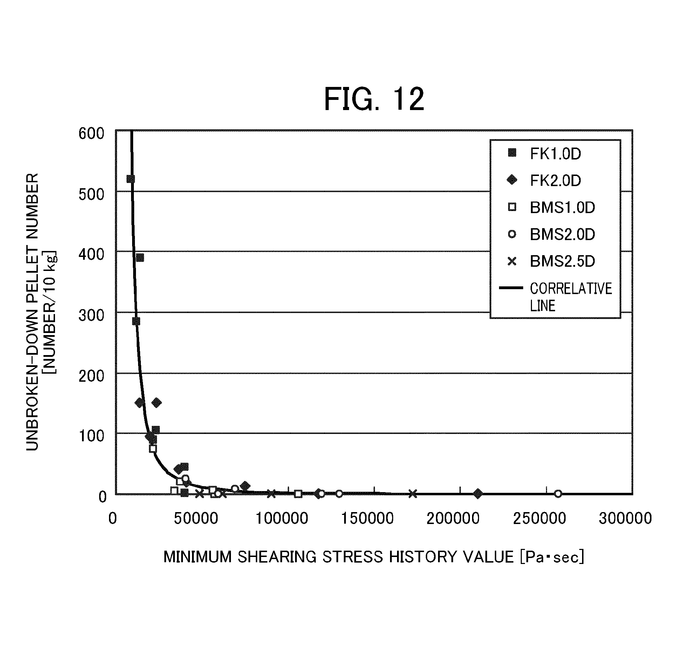

The correlative line for every Q/Ns differs, as shown in FIG. 11. Therefore, in the function in the form of the above-mentioned relational expression (I), they are approximated by the least-squares method. An approximate curve is shown in FIG. 12. As shown in FIG. 12, it could be approximated by one correlative line that is almost independent of Q/Ns. It should be noted that $\gamma$ was 3.0.

As shown in FIG. 11, it has been confirmed that the unbroken-down pellet number per unit amount will be less than a predetermined value, so long as being at least a predetermined minimum shearing stress history value.

(Determination of Manufacturing Conditions when Changing Extruder Size)

The condition of the external diameter (D) of the screw element was changed from 0.047 m to 0.069 m. $\delta$ and $\varepsilon$ of the above relational expressions (IV) and (V) were examined by the aforementioned method so that the specific energies acting on the molten resin were equal, and determined by correcting by the method of Seikei Kakou (described in Vol. 11, No. 11, 1999, p. 910-913). $\delta$ was 2.5 and $\varepsilon$ was 0.5.

It finally gives the following expression for the mass-production equipment.

[Math. 12]

$$N = 10^{11.5042} \left( \frac{T_{min}}{\left( \frac{KQ}{D^3 Ns} \right)^{3.0}} \right)^{-2.2000} \quad (VIII)$$

(K=1.03823×10-4[m3],D3=0.3285[m3])

So long as using the above expression arrived at by adjusting so that the specific energies are equal, it is possible to confirm the conditions at which the unbroken-down pellet number becomes 0 by deriving the minimum shearing stress history value through simulation.

(Simple Method of Determining Manufacturing Conditions)

The above-mentioned relational expression (VII) is used.

(Approximate Curve-Creating Step)

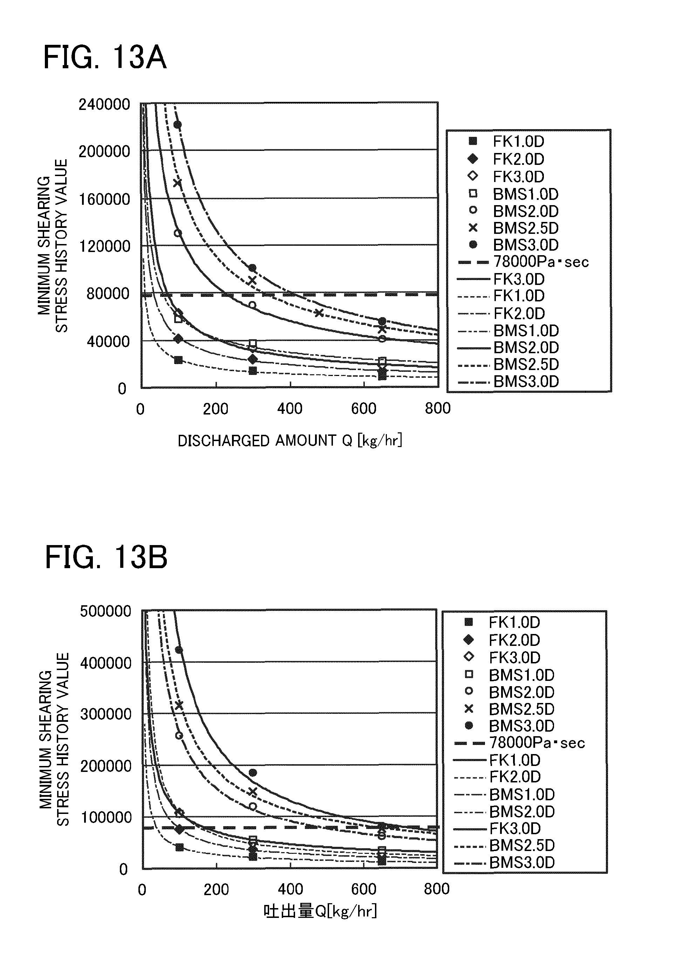

Based on the data obtained upon deriving the relational expression (VII), the relationship between the discharged amount and the minimum shearing stress history value was derived. The derivation results are shown in FIG. 13(a). It should be noted that the approximate curves are also shown in FIG. 13(a).
The approximate curves were created by the same method for the case of Q/Ns=0.8. The results are shown in FIG. 13(b).

(Threshold $T_{min}$-Determining Step)

The conditions at which the unbroken-down pellet number N (number/10 kg of pellets) becomes less than 1 was 78000 Pa·sec when obtained from FIG. 12.
When setting so that the unbroken-down pellet number N (number/10 kg of pellets) becomes less than 0.4, the minimum shearing stress history value was 78000 Pa·sec when obtained from FIG. 12.

(Discharged Amount Qn-Calculating Step)

FIG. 10 shows 78000 Pa·sec with a dotted line. The discharged amounts at which the minimum shearing stress history value becomes 78000 Pa·sec on the respective approximate curves in the cases of Q/Ns=1.0 and 0.8 are summarized in Table 2.

[Table 2]

|  | FK | | | BMS | | | |
|---|---|---|---|---|---|---|---|
| L/D | 1.0D | 2.0D | 3.0D | 1.0D | 2.0D | 2.5D | 3.0D |
| Q/Ns=1.0 (kg/hr/rpm) | 10 | 35 | 75 | 65 | 250 | 360 | 435 |
| Q/Ns=0.8 (kg/hr/rpm) | 13 | 40 | 160 | 180 | 510 | 675 | 745 |

(Relational Expression-Deriving Step, Manufacturing Condition-Determining Step)

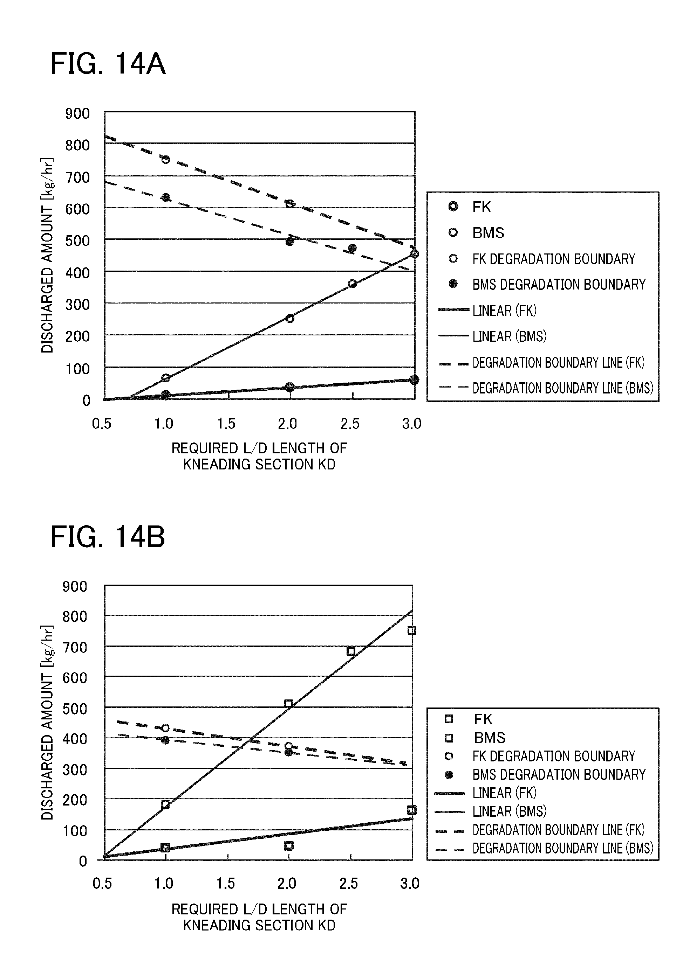

The results of Table 2 are summarized in FIG. 14. Since each straight line shown in FIG. 14 shows the maximum discharged amount at which the unbroken-down pellets become a predetermined value for every L/D, it is possible to easily determine the manufacturing conditions. In addition, FIG. 14 also shows lines indicating the temperature of the resin degradation boundary (degradation boundary lines). The manufacturing conditions must be selected from a discharged amount up to a point of intersection with the degradation boundary line.

In addition, it has been confirmed that the selectable range of manufacturing conditions widens by using a screw element having notches in the flight portion in the kneading portion 21 (FIG.14).

**Claims**

1. A simulation device for deriving a manufacturing condition that holds the number of pellets N containing glass fibers that are not broken down, per unit amount below a predetermined value when a thermoplastic resin and glass fiber bundles are kneaded in an extruder and thermoplastic resin composition pellets reinforced with glass fibers that are not broken down, are manufactured, the device comprising:

an inputting means for inputting information to derive the following expression (I);
a manufacturing condition-calculating means for deriving the following expression (I) based on the information inputted into said inputting means, to calculate the manufacturing condition that said number of pellets reinforced with glass fibers that are not broken down, N, per unit amount, is below the predetermined value; and
an outputting means for outputting said manufacturing condition calculated in said manufacturing condition-calculating means; wherein

the information inputted into said inputting means comprises multiple sets of:

(L/D) which represents the length of a screw element arranged in a portion for kneading said thermoplastic resin and said glass fiber bundles in the extruder as a multiple of the external diameter (D) of the screw element;
the discharged amount Q of the glass fiber-reinforced thermoplastic resin composition;
a screw revolution speed Ns of said screw element; and
a minimum shearing stress history value $T_{min}$ which is the smallest value among time integration values, on performing time integration of said number of pellets reinforced with glass fibers that are not broken down, N, per unit amount, and the shearing stress, which is applied to the glass fiber bundles in said extruder after the bundles are supplied to said extruder, with regard to said L/D, said discharged amount Q and said screw revolution speed Ns:
[Math. 1]

$$N = 10^{\alpha} \left\{ \frac{T_{min}}{\left(\frac{Q}{Ns}\right)^{\gamma}} \right\}^{-\beta} \qquad (\mathrm{I})$$

(in the above expression (I), all of $\alpha$, $\beta$, and $\gamma$ are constants more than 0).

2. The simulation device according to Claim 1, wherein said expression (I) is the following expression (II) when the external diameter of the screw element for kneading said thermoplastic resin and said glass fiber bundles is changed:
[Math. 2]

$$N = 10^{\alpha} \left\{ \frac{T_{min}}{\left(\frac{(d2/d1)^{\delta} Q}{(d2/d1)^{-\varepsilon} Ns}\right)^{\gamma}} \right\}^{-\beta} \qquad (\mathrm{II})$$

(in the above expression (II), d1 is said external diameter before the change, d2 is said external diameter after change, and all of $\alpha$, $\beta$, $\gamma$, $\delta$, and $\varepsilon$ are constants more than 0).

3.  The simulation device according to Claim 1 or 2, wherein said manufacturing condition-calculating means comprises:

    an approximate curve-creating step for creating an approximate curve which shows the relationship between said discharged amount Q and said minimum shearing stress history value $T_{min}$ with respect to each of a plurality of said L/D conditions;
    a threshold $T_{min}$-determining step for determining a threshold $T_{min}$, which is the minimum shearing stress history value $T_{min}$ at which said number of pellets N per unit amount is below said predetermined value, based on said expression (I);
    a discharged amount Qn-calculating step for calculating each discharged amount Qn with said threshold $T_{min}$ from each approximate curve; and
    a relational expression-deriving step for deriving a relational expression between said L/D and said Qn; wherein said simulation device selects the manufacturing condition based on said relational expression.

4.  The simulation device according to any one of Claims 1 to 3, wherein said screw element is a backward-feeding screw element which has a notch in a flight portion.

5.  A program for realizing the function of the simulation device according to any one of Claims 1 to 4 on a computer.

6.  A computer-readable recording medium which records the program according to Claim 5.

EP 2 610 041 A1

# FIG. 1

RESIN PLASTICIZING SECTION

KNEADING SECTION

HOPPER

AUXILIARY-MATERIAL
FEED PORT

C1　C2　C3　C4　C5　C6　C7　C8　C9　C10　C11　C12　C13

FEED PART

PLASTICIZING
PART

TRANSPORT
PART

KNEADING
SECTION 1

KNEADING
SECTION 21

KNEADING SECTION 22

KNEADING SECTION 2

# FIG. 2

INPUTING MEANS

MANUFACTURING
CONDITION-CALCULATING
MEANS

OUTPUTTING MEANS

# FIG. 3

START

DERIVE EXPRESSION (III) — S11

HAVE NUMBER OF EXPRESSIONS REQUIRED IN DERIVATION OF $\gamma$ BEEN OBTAINED? — S12

NO

YES

DETERMINE EXPRESSION (III) TO SERVE AS BASIS, AND DETERMINE $\alpha$ AND $\beta$ — S13

DERIVE EXPRESSION (I) BY DETERMINING $\gamma$ — S14

S1

SUBSTITUTE Ns, Q AND Tmin OF MANUFACTURING CONDITION TO BE CONSIDERED INTO EXPRESSION (I) — S21

IS VALUE CALCULATED BY SUBSTITUTING LESS THAN 1? — S22

NO

YES

OUTPUT MANUFACTURING CONDITIONS — S23

IS VALUE CALCULATED BY SUBSTITUTING LESS THAN 1? — S24

YES

NO

S2

END

# FIG. 4

START

↓

DERIVE EXPRESSIONS (IV) AND (V) — S3

↓

DERIVE EXPRESSION (III) — S4

↓

DERIVATION OF MANUFACTURING CONDITIONS — S2

↓

END

# FIG. 5

```
┌ ─ ─ ─ ─ ─ ─ ─ ─ ─ ─ ─ ─ ─ ─ ─ ─ ─ ─ ─ ─ ─ ─ ─ ─ ┐
│   ┌──────────────────────────────┐              │        S2
│   │  APPROXIMATE CURVE-CREATING   │   S2A      ┌─┤
│   │           STEP                │            │ │
│   └──────────────────────────────┘            │ │
│                  │                             │ │
│                  ▼                             │ │
│   ┌──────────────────────────────┐            │ │
│   │  THRESHOLD Tmin-DETERMINING   │   S2B      │ │
│   │           STEP                │            │ │
│   └──────────────────────────────┘            │ │
│                  │                             │ │
│                  ▼                             │ │
│   ┌──────────────────────────────┐            │ │
│   │   DISCHARGED AMOUNT Qn-       │   S2C      │ │
│   │      CALCULATING STEP         │            │ │
│   └──────────────────────────────┘            │ │
│                  │                             │ │
│                  ▼                             │ │
│   ┌──────────────────────────────┐            │ │
│   │   RELATIONAL EXPRESSION-      │   S2D      │ │
│   │       DERIVING STEP           │            │ │
│   └──────────────────────────────┘            │ │
│                  │                             │ │
│                  ▼                             │ │
│   ┌──────────────────────────────┐            │ │
│   │   MANUFACTURING CONDITION     │   S2E      │ │
│   │   RANGE-DETERMINING STEP      │            │ │
│   └──────────────────────────────┘            │ │
│                  │                             │ │
│                  ▼                             │ │
│   ┌──────────────────────────────┐            │ │
│   │   MANUFACTURING CONDITION     │   S2F      │ │
│   │   RANGE-OUTPUTTING STEP       │            │ │
│   └──────────────────────────────┘            │ │
│                  │                             │ │
└ ─ ─ ─ ─ ─ ─ ─ ─ ─│─ ─ ─ ─ ─ ─ ─ ─ ─ ─ ─ ─ ─ ─ ─ ─ ┘
                   ▼
           ╭───────────────╮
           │      END      │
           ╰───────────────╯
```

FIG. 6A

FIG. 6B

FIG. 6C

## FIG. 7A

## FIG. 7B

# FIG. 8A

C10   C11   C12   C13

KNEADING SECTION 21   KNEADING SECTION 22

KNEADING SECTION 2

# FIG. 8B

C10   C11   C12   C13

KNEADING SECTION 21

KNEADING SECTION 22

KNEADING SECTION 2

# FIG. 8C

C10   C11   C12   C13

KNEADING SECTION 21   KNEADING SECTION 22

KNEADING SECTION 2

# FIG. 8D

C10   C11   C12   C13

KNEADING SECTION 21

KNEADING SECTION 22

KNEADING SECTION 2

# FIG. 8E

C10   C11   C12   C13

KNEADING SECTION 21

KNEADING SECTION 22

KNEADING SECTION 2

FIG. 9A

FIG. 9C

FIG. 9B

FIG. 9D

FIG. 9E

# FIG. 10

## FIG. 11

# FIG. 12

## FIG. 13A

## FIG. 13B

FIG. 14A

FIG. 14B

| INTERNATIONAL SEARCH REPORT | International application No. |
|---|---|
| | PCT/JP2011/067120 |

A. CLASSIFICATION OF SUBJECT MATTER
*B29B7/58*(2006.01)i, *B29B7/48*(2006.01)i, *B29B9/06*(2006.01)i, *B29B9/14*(2006.01)i, *B29C47/92*(2006.01)i

According to International Patent Classification (IPC) or to both national classification and IPC

B. FIELDS SEARCHED

Minimum documentation searched (classification system followed by classification symbols)
B29B7/00-9/16, B29C47/00-47/96

Documentation searched other than minimum documentation to the extent that such documents are included in the fields searched
| Jitsuyo Shinan Koho | 1922-1996 | Jitsuyo Shinan Toroku Koho | 1996-2011 |
| Kokai Jitsuyo Shinan Koho | 1971-2011 | Toroku Jitsuyo Shinan Koho | 1994-2011 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| A | JP 8-60001 A (Toray Industries, Inc.), 05 March 1996 (05.03.1996), entire text & US 5679456 A & US 6428728 B1 | 1-6 |
| A | JP 2002-18842 A (Sumitomo Chemical Co., Ltd.), 22 January 2002 (22.01.2002), entire text (Family: none) | 1-6 |
| A | JP 9-29819 A (Asahi Chemical Industry Co., Ltd.), 04 February 1997 (04.02.1997), entire text (Family: none) | 1-6 |

[X] Further documents are listed in the continuation of Box C.      [ ] See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 11 August, 2011 (11.08.11) | 23 August, 2011 (23.08.11) |

| Name and mailing address of the ISA/ | Authorized officer |
|---|---|
| Japanese Patent Office | |
| Facsimile No. | Telephone No. |

Form PCT/ISA/210 (second sheet) (July 2009)

**INTERNATIONAL SEARCH REPORT**

International application No.

PCT/JP2011/067120

C (Continuation).   DOCUMENTS CONSIDERED TO BE RELEVANT

| Category* | Citation of document, with indication, where appropriate, of the relevant passages | Relevant to claim No. |
|---|---|---|
| A | JP 7-137113 A  (Sekisui Chemical Co., Ltd.), 30 May 1995 (30.05.1995), entire text (Family: none) | 1-6 |
| A | JP 2010-654 A  (The Japan Steel Works, Ltd.), 07 January 2010 (07.01.2010), entire text (Family: none) | 1-6 |
| A | WO 2006/123824 A1  (Polyplastics Co., Ltd.), 23 November 2006 (23.11.2006), entire text & KR 10-2008-0007606 A   & CN 101175619 A | 1-6 |

Form PCT/ISA/210 (continuation of second sheet) (July 2009)

# EP 2 610 041 A1

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP H11512666 B
- JP 2002120271 A

**Non-patent literature cited in the description**

- *Seikei Kakou,* 1999, vol. 11 (11), 910-913